# FASCICULE DE BREVET EUROPEEN

(11) **EP 3 355 379 B1**
(45) Date de publication et mention de la délivrance du brevet: **09.10.2019**
(21) Numéro de dépôt: 17210878.9
(22) Date de dépôt: 28.12.2017
(51) Int. Cl.: H01M 2/02, H01M 2/20, H01M 2/30, H01M 10/04, H01M 10/0525

(54) **BATTERIE À CONTACTS EN FACE AVANT ET EN FACE ARRIÈRE**
BATTERIE MIT VORDER- UND RÜCKSEITIGEN KONTAKTFLÄCHEN
BATTERY WITH CONTACTS ON THE FRONT AND REAR

(30) Priorité: 31.01.2017 FR 1750771
(43) Date de publication de la demande: 01.08.2018
(73) Titulaire: STMicroelectronics (Tours) SAS, 37100 Tours (FR)
(72) Inventeur: LADROUE, Julien, 37380 MONNAIE (FR); BOUFNICHEL, Mohamed, 37380 MONNAIE (FR)
(74) Mandataire: Cabinet Beaumont

(56) Documents cités:
- EP-A1- 2 299 515
- DE-A1-102015 201 655
- US-A1- 2015 380 710

## Description

### Domaine

La présente demande concerne une batterie à contacts en face avant et en face arrière et un procédé de modification d'une batterie ayant des contacts d'anode et de cathode en face avant en une batterie ayant des contacts d'anode et de cathode en face avant et en face arrière.

### Exposé de l'art antérieur

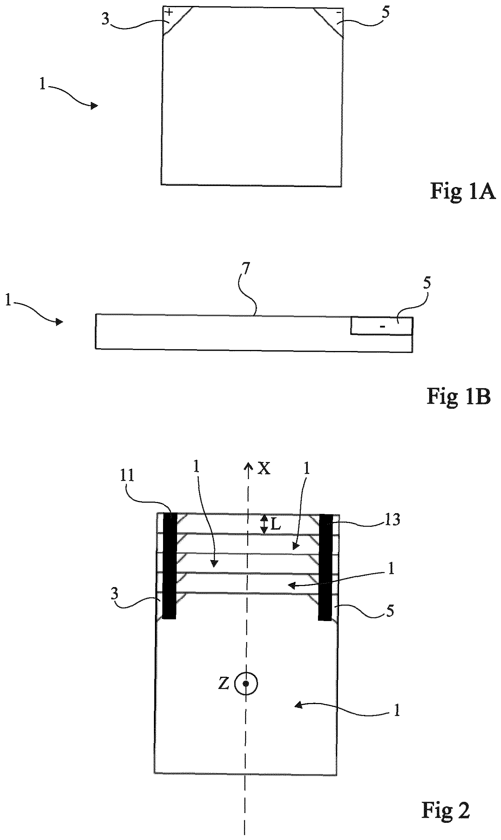

Les figures 1A et 1B illustrent un composant électronique 1 plan de forme carrée. Le composant électronique 1 peut être par exemple une microbatterie ou une batterie au lithium.

La figure 1A est une vue de dessus. Le composant 1 comprend deux métallisations de contact 3 et 5 par exemple les bornes de cathode (+) et d'anode (-) d'une batterie. Les métallisations 3 et 5 sont positionnées sur un bord du composant 1, par exemple sur deux coins consécutifs d'une face supérieure 7 du composant 1. Chaque métallisation de contact 3, 5 est par exemple de forme triangulaire et a un sommet correspondant à un coin du composant 1.

La figure 1B est une vue de côté du composant électronique 1. La métallisation de contact 5 est positionnée dans un coin de la face supérieure 7 du composant 1 et est non traversante. Il en est de même pour la métallisation de contact 3, non visible en figure 1B.

La figure 2 illustre un exemple de montage parallèle de composants électroniques 1 du type de celui présenté en figures 1A et 1B. Les composants sont empilés suivant un axe Z orthogonal au plan des composants et de la figure, et sont décalés les uns par rapport aux autres d'une longueur L, suivant un axe X orthogonal à l'axe Z et au côté du composant portant les métallisations 3 et 5. La longueur L est choisie pour laisser apparaître les métallisations de contact 3 et 5 de chaque composant 1 successif. Pour réaliser un montage parallèle, les métallisations de contact 3 et 5 des composants 1 sont respectivement interconnectées par des connexions 11 et 13, par exemple des traits de soudure.

Le montage de la figure 2 présente l'inconvénient d'être encombrant et peu fiable lorsqu'il s'agit d'empiler un grand nombre de composants.

Le document US 2015/0380710 concerne un dispositif de maintien de batterie, et des boitiers de batterie.

Le document EP 2 299 515 concerne un procédé d'encapsulation d'une batterie de type lithium-ion en couches minces directement sur le substrat.

Le document DE 10 2015 201 655 concerne une cellule de batterie et un système de batterie.

### Résumé

Un mode de réalisation prévoit de rendre accessible les contacts d'anode et de cathode d'une batterie sur les deux faces de ladite batterie.

Ainsi un mode de réalisation prévoit une structure de batterie ayant des contacts d'anode et de cathode en face avant et en face arrière comprenant une batterie ayant des contacts d'anode et de cathode en face avant uniquement, cette batterie étant enveloppée dans un film comprenant une couche conductrice et une couche isolante, la couche conductrice reposant sur les contacts d'anode et de cathode de la batterie et étant interrompue entre ces contacts d'anode et de cathode, et la couche isolante comprenant des ouvertures sur les faces avant et arrière de la batterie pour former des contacts d'anode et de cathode de la structure de batterie, la batterie comprenant en outre un bloc (50) comprenant un ensemble de couches actives.

Selon un mode de réalisation, le film est fixé à la batterie par une couche adhésive.

Selon un mode de réalisation, une première cavité et une deuxième cavité traversent la couche conductrice et la couche adhésive, la première cavité étant positionnée au-dessus du contact d'anode et la deuxième cavité étant positionnée au-dessus du contact de cathode, lesdites cavités étant remplies d'un matériau conducteur.

Un autre mode de réalisation prévoit un procédé de modification d'une batterie ayant des contacts d'anode et de cathode en face avant, comprenant : recouvrement de la face avant de la batterie par un film comprenant une couche isolante et une couche conductrice, ce film étant rabattu sur la face arrière de la batterie, réalisation d'une tranchée dans la couche conductrice pour interrompre celle-ci entre les contacts d'anode et de cathode de face avant de la batterie, réalisation d'ouvertures dans la couche isolante de façon à laisser apparaître des contacts sur la face avant et sur la face arrière de la batterie finale.

Selon un mode de réalisation, la tranchée est réalisée avant le recouvrement de la batterie par le film.

Selon un mode de réalisation, les ouvertures sont réalisées avant le recouvrement de la batterie par le film.

Selon un mode de réalisation, le film est fixé sur la batterie par une couche adhésive.

Selon un mode de réalisation, une première cavité est réalisée dans la couche adhésive et la couche conductrice puis remplie d'un matériau conducteur pour connecter la couche conductrice et le contact d'anode, et une deuxième cavité est réalisée dans la couche adhésive et la couche conductrice puis remplie de matériau conducteur pour connecter la couche conductrice et le contact de cathode.

Selon un mode de réalisation, la couche isolante est collée à la couche conductrice.

Selon un mode de réalisation, la couche isolante a une épaisseur comprise entre 10 et 30 µm.

Selon un mode de réalisation, la couche isolante est en polytéréphtalate d'éthylène.

Selon un mode de réalisation, la couche conductrice a une épaisseur comprise entre 10 et 30 µm.

Selon un mode de réalisation, la couche conductrice est en un métal.

Selon un mode de réalisation, la couche conductrice est en aluminium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B, décrites précédemment, sont des vues de dessus et de côté d'une batterie ;
la figure 2, décrite précédemment, est une vue de dessus d'un empilement de batteries des figures 1A et 1B ;
la figure 3 est une vue en perspective d'un mode de réalisation d'une batterie ;
les figures 4A et 4B sont des vues en perspective d'empilements de batteries du type de celle de la figure 3 ;
la figure 5 est une vue en coupe détaillée d'un mode de réalisation d'une batterie à une étape intermédiaire d'un procédé de modification d'une batterie du type de celle des figures 1A et 1B ;
la figure 6 est une vue de dessus d'un film utilisé dans la batterie de la figure 5 ;
la figure 7 est une vue en coupe détaillée de la batterie de la figure 5 à une étape finale de son procédé de fabrication ; et
la figure 8 est une vue de dessus d'une variante de réalisation du film de la figure 6.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "avant", "arrière", "gauche", "droite", etc., ou relative, tels que les termes "dessus", "dessous", "supérieur", "inférieur", etc., il est fait référence à l'orientation des figures dans une position normale d'utilisation. Sauf précision contraire, l'expression "de l'ordre de" signifie à 10 % près, de préférence à 5 % près.

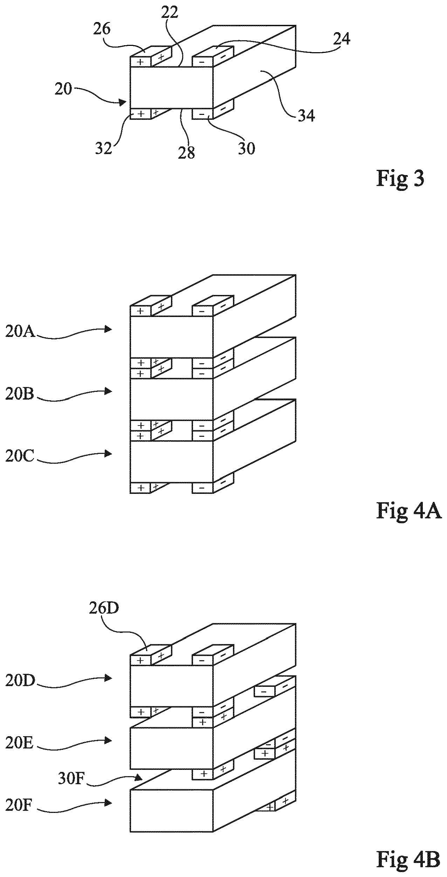

La figure 3 est une vue en perspective d'un mode de réalisation d'une batterie 20. La batterie 20 comprend, sur sa face avant 22, un contact d'anode (-) 24 et un contact de cathode (+) 26. La batterie 20 comprend en outre, sur sa face arrière 28, un contact d'anode (-) 30 et un contact de cathode (+) 32. A titre d'exemple le contact d'anode 24 est placé en regard du contact d'anode 30 et le contact de cathode 26 est placé en regard du contact de cathode 32. Un bloc 34 désigne le reste de la batterie, c'est-à-dire les couches actives de la batterie, telles que les couches d'anode, de cathode et d'électrolyte, et éventuellement le substrat sur lequel la batterie est formée. La batterie 20 est par exemple une batterie au lithium, et peut être une microbatterie au lithium formé par dépôt de couches minces sur un substrat mince. Un avantage de batteries à contacts d'anode et de cathode en face avant et en face arrière est qu'il est possible de les empiler verticalement comme cela sera montré en relation avec les figures 4A et 4B.

A titre d'exemple, comme cela est représenté en figure 3, la batterie a une forme carrée ou rectangulaire, mais, à titre de variante, la batterie 20 pourrait avoir toute autre forme, par exemple circulaire. A titre d'exemple, comme cela est représenté en figure 3, les contacts d'anode et de cathode sont de forme carrée et sont disposés dans des coins de la batterie 20, mais à titre de variante, ces contacts pourront être triangulaires, polygonaux ou circulaires et être disposés de diverses façons sur la batterie 20, par exemple sur des zones en saillie.

A titre de variante, les contacts d'anode et de cathode de la batterie 20 pourront affleurer aux surfaces 22 et 28 de la batterie, voire être en léger retrait par rapport à ces surfaces 22 et 28.

Les figures 4A et 4B sont des vues en perspective de divers montages possibles de batteries 20.

La figure 4A représente un montage parallèle de trois batteries 20A, 20B et 20C de la figure 3. Les batteries 20A, 20B et 20C sont empilées de façon à :
- positionner le contact d'anode de face arrière de chaque batterie supérieure sur le contact d'anode de face avant de la batterie immédiatement inférieure ; et
- positionner le contact de cathode de face arrière de chaque batterie supérieure sur le contact de cathode de face avant de la batterie immédiatement inférieure.

Le contact de cathode de la batterie obtenue par le montage est formé par les contacts de cathode des batteries 20A, 20B et 20C. Le contact d'anode de la batterie obtenue par le montage est formé par les contacts d'anode des batteries 20A, 20B et 20C. En pratique, les prises de contact pourront s'effectuer sur les contacts d'anode et de cathode de la batterie supérieure 20A du montage ou sur les contacts d'anode et de cathode de la batterie inférieure 20C du montage.

La figure 4B représente un montage série de trois batteries 20D, 20E et 20F de la figure 3. Dans ce cas, les batteries 20D, 20E et 20F sont empilés verticalement, et chaque batterie subit une rotation de 90 degrés par rapport à la précédente, afin de placer le contact d'anode de face arrière de la batterie supérieure en regard du contact de cathode de face avant de la batterie immédiatement inférieure.

Le contact de cathode de la batterie obtenue par le montage est formé par le contact de cathode 26D de la batterie supérieure 20D du montage. Le contact d'anode de la batterie obtenue par le montage est formé par le contact d'anode 30F de la batterie inférieure 20F du montage.

Les batteries sont fixées les unes aux autres par exemple avec une colle conductrice disposée au niveau des contacts à relier. Dans le cas de batteries comprenant des contacts d'anode et de cathode en léger retrait, la quantité de colle conductrice sera ajustée afin d'assurer une bonne connexion électrique entre deux contacts en regard à connecter. L'ensemble peut être noyé dans un matériau d'encapsulation.

De plus, afin d'obtenir des montages mécaniquement robustes, dans le cas de batteries comprenant des contacts d'anode et de cathode en saillie, il est possible d'utiliser des entretoises (non représentées sur les figures 4A et 4B) à disposer entre les batteries. Dans le cas de contacts affleurant ou en léger retrait, les batteries peuvent simplement fixées deux à deux par un matériau adhésif.

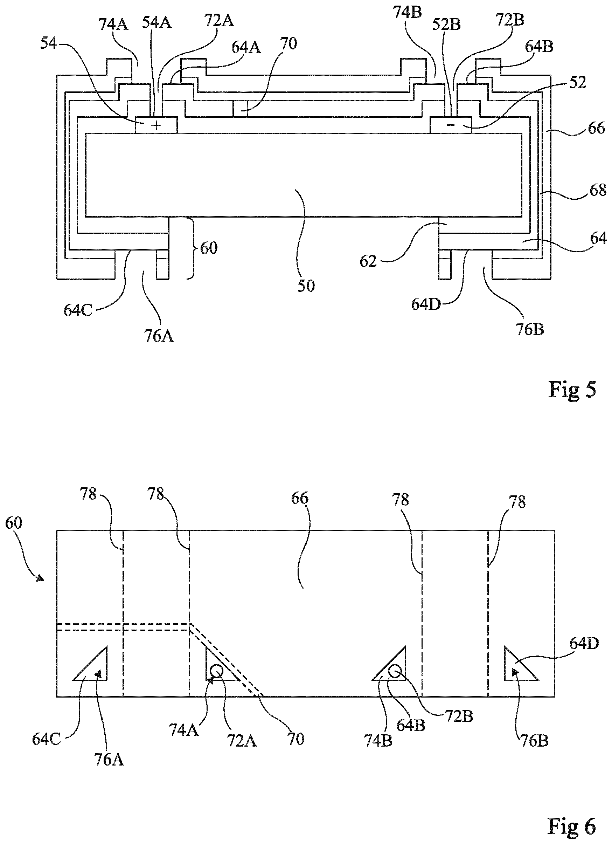

La figure 5 est une vue en coupe d'une étape intermédiaire d'un mode de réalisation d'un procédé de modification d'une batterie initiale à contacts en face avant du type de celle décrite en relation avec les figures 1A et 1B en une batterie finale à contacts en face avant et en face arrière du type de celle décrite en relation avec la figure 3.

La batterie initiale comprend un bloc 50, un contact d'anode 52 et un contact de cathode 54. Le bloc 50 désigne l'ensemble des couches actives de la batterie initiale et par exemple le substrat sur lequel elle est réalisée. Le contact d'anode 52 est disposé sur la face supérieure du bloc 50, sur la droite de la figure 5. Le contact de cathode 54 est disposé sur la face supérieure du bloc 50, sur la gauche de la figure 5.

Un film 60 est disposé sur la face avant de la batterie initiale puis rabattu sur ses côtés et sa face arrière pour former la batterie finale. Le film 60 est par exemple fixé sur la batterie à l'aide d'une couche adhésive 62. La couche adhésive 62 est par exemple un polymère (colle acrylique, ou à solvant ou termofusible). La couche adhésive 62 peut avoir une épaisseur comprise entre 10 et 30 µm, par exemple de l'ordre de 25 µm. Le film 60 comprend une couche conductrice 64 en contact avec la couche adhésive 62. La couche conductrice 64 est par exemple en un métal, par exemple de l'aluminium. La couche conductrice 64 peut avoir une épaisseur comprise entre 10 et 30 µm, par exemple de l'ordre de 25 µm. La couche conductrice 64 est collée à une couche isolante 66 par l'intermédiaire d'une couche de colle 68. La couche isolante 66 est par exemple en un polymère couramment appelé PET (PolyEthylene Terephtalate). La couche isolante 66 peut avoir une épaisseur comprise entre 10 et 30 µm, par exemple de l'ordre de 23 µm. La couche de colle 68 est par exemple en un polymère (colle acrylique ou à solvant ou thermofusible). La couche de colle 68 peut avoir une épaisseur comprise entre 1 et 10 µm, par exemple de l'ordre de 2 µm.

Une tranchée 70 est réalisée dans la couche conductrice 64 du film 60 afin d'interrompre cette couche conductrice entre le contact d'anode et le contact de cathode, de telle sorte que les contacts d'anode 52 et de cathode 54 ne soient pas électriquement connectés par la couche conductrice 64. La tranchée 70 est par exemple réalisée par gravure laser, par exemple à l'aide d'un laser à ytterbium. La tranchée 70 a une largeur comprise entre 20 µm et 2 mm, par exemple de l'ordre de 1 mm.

Des ouvertures 72A et 72B sont réalisées dans les couches 62 et 64 du film 60 en regard des contacts d'anode et de cathode de la batterie initiale. L'ouverture 72A découvre une portion 54A du contact de cathode 54. L'ouverture 72B découvre une portion 52B du contact d'anode 52. Les ouvertures 72A et 72B sont par exemple réalisées par gravure laser, par exemple à l'aide d'un laser à ytterbium. Les ouvertures 72A et 72B ont une largeur comprise entre 50 µm et 5 mm, par exemple de l'ordre de 1 mm.

Des ouvertures 74A et 74B sont réalisées dans la couche isolante 66 et la couche de colle 68 du film 60 par exemple en regard des contacts d'anode et de cathode 52 et 54 de la batterie initiale. Les ouvertures 72A et 72B sont par exemple réalisées dans les continuités respectives des ouvertures 74A et 74B et ont une largeur inférieure à celle des ouvertures 74A et 74B. L'ouverture 74A découvre une portion 64A de la couche conductrice 64. L'ouverture 74B découvre ainsi une portion 64B de la couche conductrice 64. Les ouvertures 74A et 74B sont par exemple réalisées par gravure laser, par exemple à l'aide d'un laser à dioxyde de carbone. Les ouvertures 74A et 74B ont par exemple une largeur comprise entre 100 µm et 20 mm, par exemple de l'ordre de 5 mm.

Des ouvertures 76A et 76B sont réalisées dans les couches 66 et 68 du film 60 du côté de la face arrière de la batterie finale. Les ouvertures 76A et 76B sont par exemple réalisées en regard des ouvertures 74A et 74B. L'ouverture 76A découvre une portion 64C de la couche conductrice 64. L'ouverture 76B découvre une portion 64D de la couche conductrice 64. Les ouvertures 76A et 76B sont par exemple réalisées par gravure laser, par exemple à l'aide d'un laser à CO₂. Les ouvertures 76A et 76B ont par exemple une largeur comprise entre 100 µm et 20 mm, par exemple de l'ordre de 5mm.

A titre d'exemple, avant montage sur la batterie, le film est positionné face conductrice 64 en avant. La tranchée 70 est gravée dans la couche conductrice 64. Le film est ensuite positionné face isolante en avant. Les ouvertures 74A, 74B, 76A et 76B sont gravées dans la couche isolante et dans la couche de colle. Puis, la couche adhésive 62 est fixée sur la face libre de la couche conductrice 64 du film 60. Les ouvertures 72A et 72B sont gravées dans la couche conductrice 64 et dans la couche adhésive 62. Le film est par exemple ensuite déposé sur la batterie initiale, par exemple par laminage.

La figure 6 est une vue de dessus d'un exemple de réalisation d'un film 60 décrit en relation avec la figure 5 avant sa mise en place sur la batterie initiale. Le film 60 est par exemple de forme rectangulaire et a des dimensions adaptées aux dimensions de la batterie à recouvrir. Le film 60 est rabattu sur la batterie selon des pliures 78 symbolisées en pointillés.

Les ouvertures 72A et 72B sont par exemple de forme circulaire et traverse entièrement le film 60. Les ouvertures 74A et 74B sont par exemple de forme triangulaire. Les ouvertures 76A et 76B sont par exemple de forme triangulaire. Un exemple de parcours de la tranchée 70 est symbolisé en pointillés.

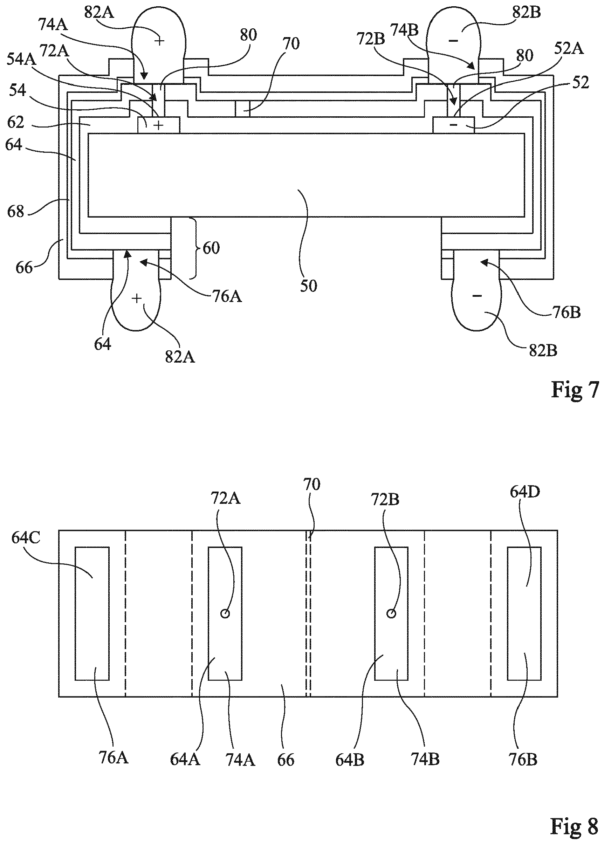

La figure 7 est une vue en coupe d'une étape ultérieure à celle décrite en relation avec la figure 5. A cette étape, les contacts d'anode et de cathode de la batterie finale sont formés. Pour cela, les ouvertures 72A et 72B sont remplies d'un matériau conducteur 80, par exemple une colle époxy métal (argent), ou des microbilles de soudure fluables (BUMP) ou encore conductrice (jet d'encre). Ainsi, les contacts d'anode et de cathode 52 et 54 de la batterie initiale sont reliés électriquement à la couche conductrice 64. La tranchée 70 empêche le court-circuit de l'anode et de la cathode de la batterie initiale. Ensuite, des plots conducteurs 82A sont formés dans les ouvertures 74A et 76A. Les plots conducteurs 82A constituent les contacts de cathode de la batterie finale. Des plots conducteurs 82B sont formés dans les ouvertures 74B et 76B. Les plots conducteurs 82B constituent les contacts d'anode de la batterie finale.

A titre de variante, la formation des plots 82A et 82B peut être omise. Les portions 64A, 64B, 64C et 64D de la couche conductrice 64 forment alors des contacts d'anode et de cathode sur les deux faces de la batterie.

A titre de variante, certaines portions 64A, 64B, 64C et 64D de la couche conductrice 64 pourront être munies de plots conducteurs alors que d'autres en seront dépourvus. Par exemple, les contacts d'anode et de cathode d'une même face de la batterie pourront être munis de plots conducteurs alors que les contacts d'anode et de cathode de la face opposée ne le seront pas. Ainsi, les plots conducteurs d'une face de la batterie pourront être adaptés à être connectés aux contacts sans plots conducteurs de la face opposée d'une deuxième batterie.

La figure 8 est une vue de dessus d'une variante de réalisation d'un film 60. Un avantage de l'utilisation d'un film tel que le film 60 est qu'il est possible de réaliser des contacts d'anode et de cathode de diverses tailles et de diverses formes. Ainsi, le film 60 comprend des ouvertures 74A, 74B, 76A et 76B de forme rectangulaire laissant apparaître des portions 64A, 64B, 64C et 64D de la couche conductrice 64 de surface supérieure à celles du film 60 présentés en relation avec la figure 6. De façon similaire, on pourrait aussi réduire la surface des portions 64A, 64B, 64C et 64D.

Des modes de réalisation particuliers ont été décrits. Diverses variantes et modifications apparaîtront à l'homme de l'art. En particulier, il est possible de réaliser la tranchée 70 et les ouvertures 72A, 72B, 74A, 74B, 76A et 76B une fois que le film 60 est déposé sur la batterie.

Il est clair pour l'homme de l'art qu'il est possible de reporter des contacts sur les faces latérales d'une batterie et pas seulement sur sa face arrière.

Le film pourrait avoir une forme en croix et pourrait ainsi recouvrir les quatre faces latérales d'une batterie en forme de pavé droit. De même, le film pourrait être adapté à différentes formes de batteries.

Il est clair pour l'homme de l'art qu'il serait possible de réaliser des contacts en face avant de la batterie sans que ces contacts soit positionnés directement à l'aplomb des contacts de la batterie initiale.

Le procédé de modification décrit ici pourra s'appliquer à d'autres composants électroniques qu'une batterie, par exemple des puces électroniques, des circuits intégrés, etc... Plus particulièrement ce procédé de modification pourra s'appliquer à des composants ayant plus de deux bornes à reporter sur d'autres faces desdits composants.

Divers modes de réalisation avec diverses variantes ont été décrits ci-dessus.

## Revendications

1. Structure de batterie ayant des contacts d'anode (82B) et de cathode (82A) en face avant et en face arrière comprenant une batterie ayant des contacts d'anode (52) et de cathode (54) en face avant uniquement, cette batterie étant enveloppée dans un film (60) comprenant une couche conductrice (64) et une couche isolante (66), la couche conductrice (64) reposant sur les contacts d'anode (52) et de cathode (54) de la batterie et étant interrompue entre ces contacts d'anode (52) et de cathode (54) de telle sorte que lesdits contacts (52, 54) ne sont pas électriquement connectés par la couche conductrice (64), et la couche isolante (66) comprenant des ouvertures (74A, 74B, 76A, 76B) sur les faces avant et arrière de la batterie pour former des contacts d'anode (82B) et de cathode (82A) de la structure de batterie,
la batterie comprenant en outre un bloc (50) comprenant un ensemble de couches actives.

2. Structure de batterie selon la revendication 1, dans laquelle le film (60) est fixé à la batterie par une couche adhésive (62).

3. Structure de batterie selon la revendication 2, dans laquelle une première cavité et une deuxième cavité (72A, 72B) traversent la couche conductrice (64) et la couche adhésive (62), la première cavité étant positionnée au-dessus du contact d'anode et la deuxième cavité étant positionnée au-dessus du contact de cathode, lesdites cavités étant remplies d'un matériau conducteur.

4. Procédé de modification d'une batterie ayant des contacts d'anode (52) et de cathode (54) en face avant, comprenant :
recouvrement de la face avant de la batterie par un film (60) comprenant une couche isolante (66) et une couche conductrice (64), ce film (60) étant rabattu sur la face arrière de la batterie,
réalisation d'une tranchée (70) dans la couche conductrice (64) pour interrompre celle-ci entre les contacts d'anode (52) et de cathode (54) de face avant de la batterie de telle sorte que les contacts d'anode (52) et de cathode (54) ne soient pas électriquement connectés par la couche conductrice (64),
réalisation d'ouvertures (74A, 74B, 76A, 76B) dans la couche isolante (66) de façon à laisser apparaître des contacts sur la face avant et sur la face arrière de la batterie finale.

5. Procédé selon la revendication 4, dans lequel la tranchée (70) est réalisée avant le recouvrement de la batterie par le film (60).

6. Procédé selon la revendication 4 ou 5, dans lequel les ouvertures (74A, 74B, 76A, 76B) sont réalisées avant le recouvrement de la batterie par le film (60).

7. Procédé selon l'une quelconque des revendications 4 à 6, dans lequel le film (60) est fixé sur la batterie par une couche adhésive (62).

8. Procédé selon la revendication 7, dans lequel une première cavité (72B) est réalisée dans la couche adhésive (62) et la couche conductrice (64) puis remplie d'un matériau conducteur (80) pour connecter la couche conductrice (64) et le contact d'anode (52), et une deuxième cavité (72A) est réalisée dans la couche adhésive (62) et la couche conductrice (64) puis remplie de matériau conducteur (80) pour connecter la couche conductrice (64) et le contact de cathode (54).

9. Procédé selon l'une quelconque des revendications 4 à 8, dans lequel la couche isolante (66) est collée à la couche conductrice (64).

10. Procédé selon l'une quelconque des revendications 4 à 9, dans lequel la couche isolante (66) a une épaisseur comprise entre 10 et 30 µm.

11. Procédé selon l'une quelconque des revendications 4 à 10, dans lequel la couche isolante (66) est en polytéréphtalate d'éthylène.

12. Procédé selon l'une quelconque des revendications 4 à 11, dans lequel la couche conductrice (64) a une épaisseur comprise entre 10 et 30 µm.

13. Procédé selon l'une quelconque des revendications 4 à 12, dans lequel la couche conductrice (64) est en un métal.

14. Procédé selon la revendication 13, dans lequel la couche conductrice (64) est en aluminium.

## Patentansprüche

1. Batteriestruktur mit Anoden- (82B) und Kathoden- (82A) Kontakten auf der Vorderseite und auf der Rückseite, aufweisend eine Batterie mit Anoden- (52) und Kathoden- (54) Kontakten nur auf der Vorderseite, wobei diese Batterie von einem Film (60) ummantelt ist, der eine leitende Schicht (64) und eine isolierende Schicht (66) aufweist, wobei die leitende Schicht (64) auf den Kontakten der Anode (52) und der Kathode (54) der Batterie aufliegt und zwischen diesen Kontakten der Anode (52) und der Kathode (54) unterbrochen ist, so dass die Kontakte (52, 54) nicht elektrisch durch die leitende Schicht (64) verbunden sind, und wobei die isolierende Schicht (66) Öffnungen (74A, 74B, 76A, 76B) auf der Vorder- und Rückseite der Batterie aufweist, um Anoden- (82B) und Kathoden- (82A) Kontakte der Batteriestruktur zu bilden,
wobei die Batterie ferner einen Block (50) mit einem Satz aktiver Schichten aufweist.

2. Batteriestruktur nach Anspruch 1, bei der der Film (60) durch eine Klebeschicht (62) an der Batterie befestigt ist.

3. Batteriestruktur nach Anspruch 2, bei der ein erster Hohlraum und ein zweiter Hohlraum (72A, 72B) durch die leitende Schicht (64) und die Klebeschicht (62) hindurchgehen, wobei der erste Hohlraum über dem Anodenkontakt und der zweite Hohlraum über dem Kathodenkontakt angeordnet ist und die Hohlräume mit einem leitenden Material gefüllt sind.

4. Verfahren zum Modifizieren einer Batterie mit Anoden- (52) und Kathoden-(54) Kontakten auf der Vorderseite, aufweisend:
Abdecken der Vorderseite der Batterie mit einem Film (60), der eine isolierende Schicht (66) und eine leitende Schicht (64) aufweist, wobei der Film (60) über die Rückseite der Batterie herumgeschlagen wird,
Herstellen eines Grabens (70) in der leitenden Schicht (64), um diese zwischen den vorderseitigen Anoden- (52) und Kathoden- (54) Kontakten der Batterie zu unterbrechen, so dass die Anoden- (52) und Kathoden- (54) Kontakte durch die leitende Schicht (64) nicht elektrisch verbunden sind,
Herstellen von Öffnungen (74A, 74B, 76A, 76B) in der Isolierschicht (66), um Kontakte auf der Vorderseite und auf der Rückseite der fertigen Batterie freizulegen.

5. Verfahren nach Anspruch 4, bei dem der Graben (70) vor dem Abdecken der Batterie mit dem Film (60) hergestellt wird.

6. Verfahren nach Anspruch 4 oder 5, bei dem die Öffnungen (74A, 74B, 76A, 76B) vor dem Abdecken der Batterie mit dem Film (60) hergestellt werden.

7. Verfahren nach einem der Ansprüche 4 bis 6, bei dem der Film (60) mit einer Klebeschicht (62) auf der Batterie befestigt wird.

8. Verfahren nach Anspruch 7, bei dem ein erster Hohlraum (72B) in der Klebeschicht (62) und der leitenden Schicht (64) erzeugt wird, der dann mit einem leitenden Material (80) gefüllt wird, um die leitende Schicht (64) und den Anodenkontakt (52) zu verbinden, und ein zweiter Hohlraum (72A) in der Klebeschicht (62) und der leitenden Schicht (64) erzeugt wird, der dann mit leitendem Material (80) gefüllt wird, um die leitende Schicht (64) und den Kathodenkontakt (54) zu verbinden.

9. Verfahren nach einem der Ansprüche 4 bis 8, bei dem die isolierende Schicht (66) mit der leitenden Schicht (64) verklebt wird.

10. Verfahren nach einem der Ansprüche 4 bis 9, bei dem die isolierende Schicht (66) eine Dicke zwischen 10 und 30 µm aufweist.

11. Verfahren nach einem der Ansprüche 4 bis 10, bei dem die isolierende Schicht (66) aus Polyethylenterephthalat hergestellt ist.

12. Verfahren nach einem der Ansprüche 4 bis 11, bei dem die leitende Schicht (64) eine Dicke zwischen 10 und 30 µm aufweist.

13. Verfahren nach einem der Ansprüche 4 bis 12, bei dem die leitende Schicht (64) aus einem Metall hergestellt ist.

14. Verfahren nach Anspruch 13, bei dem die leitende Schicht (64) aus Aluminium hergestellt ist.

## Claims

1. Battery structure having anode (82B) and cathode (82A) contacts on the front face and on the rear face comprising a battery having anode (52) and cathode (54) contacts on the front face only, this battery being jacketed in a film (60) comprising a conductive layer (64) and an insulating layer (66), the conductive layer (64) resting on the anode (52) and cathode (54) contacts of the battery and being interrupted between these anode (52) and cathode (54) contacts such that said contacts (52, 54) are not electrically connected by the conductive layer (64), and the insulating layer (66) comprising openings (74A, 74B, 76A, 76B) on the front and rear faces of the battery to form anode (82B) and cathode (82A) contacts of the battery structure,
the battery further comprising a block (50) comprising a set of active layers.

2. Battery structure according to claim 1, in which the film (60) is fixed to the battery by an adhesive layer (62).

3. Battery structure according to claim 2, in which a first cavity and a second cavity (72A, 72B) pass through the conductive layer (64) and the adhesive layer (62), the first cavity being positioned above the anode contact and the second cavity being positioned above the cathode contact, said cavities being filled with a conductive material.

4. Method for modifying a battery having anode (52) and cathode (54) contacts on the front face, comprising:
covering of the front face of the battery with a film (60) comprising an insulating layer (66) and a conductive layer (64), this film (60) being folded down over the rear face of the battery,
production of a trench (70) in the conductive layer (64) to interrupt the latter between the front face anode (52) and cathode (54) contacts of the battery such that the anode (52) and cathode (54) contacts are not electrically connected by the conductive layer (64),
production of openings (74A, 74B, 76A, 76B) in the insulating layer (66) so as to reveal contacts on the front face and on the rear face of the final battery.

5. Method according to claim 4, in which the trench (70) is produced before the covering of the battery with the film (60) .

6. Method according to claim 4 or 5, in which the openings (74A, 74B, 76A, 76B) are produced before the covering of the battery with the film (60).

7. Method according to any one of claims 4 to 6, in which the film (60) is fixed onto the battery by an adhesive layer (62) .

8. Method according to claim 7, in which a first cavity (72B) is produced in the adhesive layer (62) and the conductive layer (64) then filled with a conductive material (80) to connect the conductive layer (64) and the anode contact (52), and a second cavity (72A) is produced in the adhesive layer (62) and the conductive layer (64) then filled with conductive material (80) to connect the conductive layer (64) and the cathode contact (54).

9. Method according to any one of claims 4 to 8, in which the insulating layer (66) is glued to the conductive layer (64) .

10. Method according to any one of claims 4 to 9, in which the insulating layer (66) has a thickness of between 10 and 30 µm.

11. Method according to any one of claims 4 to 10, in which the insulating layer (66) is made of polyethylene terephthalate.

12. Method according to any one of claims 4 to 11, in which the conductive layer (64) has a thickness of between 10 and 30 µm.

13. Method according to any one of claims 4 to 12, in which the conductive layer (64) is made of a metal.

14. Method according to claim 13, in which the conductive layer (64) is made of aluminium.
